# EUROPÄISCHE PATENTANMELDUNG

(11) **EP 1 845 170 A2**
(43) Veröffentlichungstag der Anmeldung: **17.10.2007**
(21) Anmeldenummer: 07007393.7
(22) Anmeldetag: 11.04.2007
(51) Int. Cl.: C23C 18/16, H05K 3/18

(54) **Verfahren zur Herstellung einer Leiterbahnstruktur sowie eine derart hergestellte Leiterbahnstruktur**

(30) Priorität: 12.04.2006 DE 102006017630; 03.04.2007 WO PCT/DE2007/000605
(71) Anmelder: LPKF Laser & Electronics AG, 30827 Garbsen (DE)
(72) Erfinder: Naundorf, Gerhard, Prof. Dr., 32657 Lemgo (DE)
(74) Vertreter: Scheffler, Jörg

(57) **Zusammenfassung**

Die Erfindung betrifft ein Verfahren zur Herstellung eines Trägermaterials (2) in stromlosen Metallisierungsbädern sowie eine nach dem Verfahren hergestellte Leiterbahnstruktur (1) auf dem Trägermaterial (2). Zu diesem Zweck wird das plattenförmige Trägermaterial (2) zunächst einer selektiven elektromagnetischen Strahlung (3) eines Nd:YAG-Lasers ausgesetzt, um die Leiterbahnstrukturen (1) auf dem Trägermaterial (2) als hochreaktive Aluminiumpartikel durch Aufbrechen von feinstverteilt in dem Trägermaterial (2) enthaltenen nicht leitenden Aluminiumnitrid zu erzeugen. Gleichzeitig wird dabei Stickstoff freigesetzt, welcher eine unerwünschte Oxidation der Aluminiumpartikel verhindert. Anschließend wird auf die Leiterbahnstruktur (1) zumindest eine Kupferschicht stromlos aufgebracht. Auf diese Weise wird ein beschleunigtes Verfahren zur haftfesten Metallisierung einer Oberflächenstruktur in stromlosen Bädern geschaffen.

## Beschreibung

Die Erfindung betrifft ein Verfahren zur Metallisierung einer Leiterbahnstruktur auf einem Trägermaterial in einem stromlosen Metallisierungsbad sowie eine nach dem Verfahren hergestellte Leiterbahnstruktur auf einem Trägermaterial.

Derartige Verfahren werden in der Praxis beispielsweise bei der Herstellung von Schaltungsträgern aus thermoplastischen Kunststoffen mittels eines Spritzgießverfahrens eingesetzt, der so genannten MID-Technologie, wobei MID gleichbedeutend mit Moulded Interconnect Device zu verstehen ist. Ziel der MID-Technologie ist es, elektrische und mechanische Funktionen in einem Bauteil zu vereinen. Die Leiterbahnen werden hierbei in das Gehäuse integriert und substituieren so die konventionelle Leiterplatte. Gewicht und Einbauraum können effektiv reduziert werden. Gegenüber alternativen Herstellungsverfahren weisen Verfahren nach der MID-Technologie den Vorteil auf, dass die Werkzeugkosten vergleichsweise niedrig gehalten werden können. Außerdem kann die Zahl der erforderlichen Prozessschritte verringert werden, sodass eine sehr wirtschaftliche Herstellung auch mittelgroßer Stückzahlen möglich ist.

Zu dem genannten Zweck sind bereits durch die DE 197 23 734 A1 und DE 197 31 346 A1 Verfahren bekannt geworden, bei denen zur Herstellung feiner, festhaftender Leiterbahnstrukturen in ein nicht leitendes Trägermaterial nicht leitende Metallchelatkomplexe eingebracht und von diesen mittels Laserstrahlung strukturiert Metallisierungskeime abgespalten werden, die in den bestrahlten Teilflächen eine nachfolgende chemisch reduktive Metallisierung initiieren.

Ein gattungsgemäßes Verfahren sowie eine nach dem Verfahren hergestellte Leiterbahnstruktur sind beispielsweise durch die WO 03/005784 A2 bekannt. Um einfach und sicher herzustellende Leiterbahnstrukturen auf Schaltungsträgern zur Verfügung zu stellen, die einen vergleichsweise geringen Anteil keimbildender Zusätze enthalten, zudem auch bei Löttemperaturen stabil sind und ferner ein einfaches und sicheres Verfahren zur Herstellung von Leiterbahnstrukturen schaffen, werden dabei thermisch hochstabile, in wässrigen, sauren oder alkalischen Metallisierungsbädern beständige und nicht lösliche, nicht leitende höhere Oxide auf der Basis von Spinelle in das Trägermaterial eingemischt, und das Trägermaterial zu Bauteilen verarbeitet oder auf Bauteile als Beschichtung aufgetragen sowie im Bereich der zu erzeugenden Leiterbahnstrukturen mittels einer elektromagnetischen Strahlung Schwermetallkeime freigesetzt und diese Bereiche dann chemisch reduktiv metallisiert.

Durch die WO 00/35259 A2 ist ein Verfahren zur Herstellung von feinen metallischen Leiterbahnstrukturen auf einem elektrisch nicht leitenden Trägermaterial beschrieben, bei dem ein elektrisch nicht leitender Schwermetallkomplex, der mit organischen Komplexbildnern aufgebaut ist, auf das Trägermaterial aufgebracht oder in das Trägermaterial eingebracht wird, das Trägermaterial im Bereich der zu erzeugenden Leiterbahnstrukturen selektiv einer UV-Strahlung ausgesetzt wird, wobei Schwermetallkeime freigesetzt werden und dieser Bereich chemisch reduktiv metallisiert wird. Dabei ist eine Feinstrukturierung der Leiterbahnen mittels eines vereinfachten und sicheren Verfahrens möglich.

Ferner beziehen sich die DE 37 08 235 A1 sowie die DE 39 42 472 A1 auf die Bearbeitung von Aluminiumnitrid-Keramiken mittels elektromagnetischer Strahlung.

Vor diesem Hintergrund liegt der Erfindung die Aufgabe zugrunde, eine Möglichkeit zu schaffen, ein weiter verbessertes Verfahren zur Metallisierung einer Leiterbahnstruktur auf einem Trägermaterial in einem stromlosen Metallisierungsbad zu schaffen. Weiterhin liegt der Erfindung die Aufgabe zugrunde, eine nach diesem Verfahren hergestellte Leiterbahnstruktur zu schaffen.

Die erstgenannte Aufgabe wird erfindungsgemäß mit einem Verfahren gemäß den Merkmalen des Anspruchs 1 gelöst. Die Unteransprüche 2 bis 10 betreffen besonders zweckmäßige Weiterbildungen der Erfindung.

Erfindungsgemäß werden also bei dem Verfahren zur Herstellung einer Leiterbahnstruktur auf einem Trägermaterial, bei dem die Leiterbahnstruktur auf einer hochmolekularen Werkstoffoberfläche des Trägermaterials als elektrisch leitfähige Oberflächenphasen mit hocheaktiven Aluminiumpartikeln durch Aufbrechen von feinstverteilt in dem Trägermaterial enthaltenen nicht leitenden Aluminiumnitrid erzeugt wird, die gleichzeitig unter Stickstoffbildung und Ablation des hochmolekularen Werkstoffes, beispielsweise ein Polymer, in hoher Konzentration freigesetzt werden, wobei die Bereiche im Umfeld der Leiterbahnstruktur unverändert verbleiben. Hierdurch wird ein beschleunigtes Verfahren zur haftfesten Metallisierung einer Oberflächenstruktur in stromlosen Bädern geschaffen, das auf der Oberfläche von stofflich modifizierten hochmolekularen Werkstoffen durch Aluminiumkeime realisiert wird. Dabei werden die Metallkeime durch elektromagnetische Strahlung aus Aluminiumnitrid freigesetzt. Die Erfindung ist gegenüber dem Stand der Technik dadurch wesentlich verbessert, dass die im Werkstoff enthaltenen elektrisch nicht leitenden Aluminiumnitrid-Partikel bei der Freisetzung der Aluminiumkeime Stickstoff abspalten und dadurch die Keime in der Stickstoffatmosphäre vor Oxidation geschützt sind. Vorteilhaft auf die Eigenschaften des Trägermaterials wirken sich auch die spezifischen Eigenschaften des eingearbeiteten Aluminiumnitrid-Pulvers aus, die zur verbesserten Wärmeleitfähigkeit, geringeren Wärmeausdehnung, verbesserter Bondbarkeit auf der Leiterbahnstruktur und günstigerer elektrischer Hochfrequenzeignung führen.

Dieser Prozess erweist sich dann als besonders Erfolg versprechend, wenn eine Metallisierung der Leiterbahnstruktur des Trägermaterials in einem stromlosen Metallisierungsbad durchgeführt wird und somit die mit hoher Keimzahl pro Flächeneinheit auf der Oberfläche des Werkstoffes entstehenden, in der Stickstoffatmosphäre vor Oxidation geschützten Keime zur beschleunigten Metallabscheidung in stromlosen Bädern wesentlich beitragen. Die Aufwachsraten der herkömmlichen chemisch-reduktiven Verfahren werden durch die freigesetzten A1-Partikel und ihre hohe Keimzahl/Flächeneinheit von etwa 0,1 µm/10 min auf 1 µm/10 min schon unmittelbar zu Beginn des Metallisierungsprozesses erhöht und damit die Wirtschaftlichkeit dieses zeitaufwendigen Fertigungsschrittes wesentlich verbessert. Die Kombination des hochmolekularen Werkstoffs, insbesondere eines Polymers mit Aluminiumnitrid vermeidet außerdem, dass bei nachfolgenden Lötprozessen auf den Leiterbahnen Elektrolyteinschlüsse des chemisch-reduktiven Bades ausgasen, da aufgrund des geringen Anteils des Aluminiumnitridpulvers von vorwiegend ca. 1% bis 10% und der Umhüllung der Aluminiumnitridpartikel durch die Werkstoffmatrix, insbesondere Kunststoffmatrix Elektrolyteinschlüsse vermieden werden. Die Kombination mit den hochmolekularen Werkstoffen führt weiterhin dazu, dass die Leiterbahnen unter Bildung von Stickstoff durch geringe Ablation von Polymer-Partikeln und Aluminiumkeimen eine im Strukturbereich mikroporöse Leiterstrukturoberfläche bilden, die eine feste Verankerung des stromlosen Metallaufbaus und dadurch eine hohe Haftfestigkeit der aufmetallisierten Leiterbahnen bewirkt. Da die Aluminiumnitridpartikel im gesamten Trägermaterial fein verteilt vorliegen, ist auch eine Aktivierung durch elektromagnetische Strahlung in Bohrungen möglich. Hierbei ist besonders die schnelle und zuverlässige chemisch-reduktive Metallabscheidung in den Durchgangsbohrungen von Vorteil. Der Zusatz von 1,0 bis 5,0% Yttriumoxid zu Aluminiumnitrid wirkt sich vorteilhaft auf die Haftfestigkeit der Metallisierung aus.

Die hochreaktiven Aluminiumpartikel der Leiterbahnstrukturen des Trägermaterials ermöglichen einen problemlosen, nahezu beliebigen Schichtaufbau durch die Metallisierung. Besonders praxisnah ist hingegen eine Weiterbildung des Verfahrens, bei dem bei der Metallisierung in dem stromlosen Metallisierungsbad zumindest Chrom, Kupfer, Nickel oder Gold aufgebracht wird, wobei sich insbesondere ein Schichtaufbau mit einzelnen Schichten aller vorstehenden Bestandteile als zweckmäßig erweist. Zudem wird dadurch eine wesentlich beschleunigte Metallisierung ermöglicht.

Der Energieeintrag zum Aufbrechen des feinstverteilt in dem Trägermaterial enthaltenen Aluminiumnitrids ist auf unterschiedliche Weise realisierbar. Besonders Erfolg versprechend ist hingegen eine Abwandlung, bei der die elektromagnetische Strahlung eines Lasers, insbesondere des Wellenlängenbereiches von 0,125 bis 11,0 µm eingesetzt wird, um so ein selektives Aufbrechen des Aluminiumnitrids durch den Laserstrahl zu ermöglichen. Selbstverständlich können die Leiterbahnstrukturen mittels des Laserstrahls schreibend oder in einem einzigen Schritt mittels einer den Energieeintrag begrenzenden Schablone erzeugt werden. Gegenüber anderen laserinduzierten Verfahren hat die als Wirksubstanz eingearbeitete Aluminiumnitridverbindung den Vorteil, dass die Zersetzung der Verbindung mit elektromagnetischer Strahlung auch mit niedriger Energiedichte möglich ist und dadurch neben Energieeinsparung auch eine höhere Lebensdauer der eingesetzten Laserquellen möglich wird.

In der Praxis erweist es als besonders sinnvoll, wenn im Bereich der zu erzeugenden Leiterbahnen mittels der elektromagnetischen Strahlung gleichzeitig hochreaktive Aluminium-Partikel unter Stickstoffbildung und Polymerabtrag freigesetzt und dann chemisch reduktiv metallisiert werden, um auf diese Weise einen zuverlässig beherrschbaren und in einem kurzen Zeitraum durchführbaren Prozess zu schaffen. Die gleichzeitige Ablation führt zu Hinterschneidungen, an denen die Aluminiumkeime an der Oberfläche anliegen und die von der Metallisierung ausgefüllt werden

Weiterhin erweist es sich als besonders Erfolg versprechend, wenn das thermisch hochstabile, in wässrigen sauren und alkalischen Metallisierungsbädern beständige und nicht lösliche Aluminiumnitridpulver in die hochmolekularen Werkstoffoberflächen des Trägermaterials mit an sich bekannten Verfahren eingearbeitet und das Trägermaterial zu Bauteilen verarbeitet oder das Trägermaterial auf Bauteile als eine Beschichtung aufgetragen wird. Hierdurch wird eine besonders vielseitige Einsatzmöglichkeit des so geschaffenen aktivierbaren Trägermaterials realisiert. Das Trägermaterial kann hierzu bei Raumtemperatur sowohl in einem flüssigen als auch in einem festen, insbesondere formbaren Zustand verfügbar sein.

Außerdem ist es ebenfalls besonders vorteilhaft, wenn gemäß einer Ausgestaltung des erfindungsgemäßen Verfahrens durch das Aufbrechen des in dem Trägermaterial enthaltenen Aluminiumnitrids die Aluminiumpartikel bei gleichzeitiger Ablation des hochmolekularen Werkstoffes, insbesondere des Polymers unter Stickstoffabspaltung gebildet und dabei eine haftvermittelnde Strukturoberfläche erzeugt wird. Hierdurch wird in einfacher Weise der Schichtaufbau durch den die Bearbeitungszone einschließenden Stickstoff, welcher der Vermeidung einer unerwünschten Oxidation dient, begünstigt, indem die Strukturoberfläche die Anhaftung verbessert. Zugleich wird der Prozess dadurch beschleunigt.

Grundsätzlich kann das Trägermaterial entsprechend dem individuellen Verwendungszweck beliebig ausgewählt werden. Für die Praxis hat sich jedoch eine Ausführungsform als besonders vorteilhaft erwiesen, bei der das nicht leitende Trägermaterial einen Kunststoff oder eine Polymerkeramik aufweist. Der letztgenannte Werkstoff ermöglicht aufgrund seiner hohen Temperaturbeständigkeit beispielsweise den Einsatz in der Umgebung von Brennkraftmaschinen und Heizeinrichtungen oder als integraler Bestandteil eines Bauelementes derselben.

Die zweitgenannte Aufgabe, eine nach diesem Verfahren geschaffene Leiterbahnstruktur auf einem Trägermaterial zu schaffen, wird erfindungsgemäß dadurch gelöst, dass die Leiterbahnstrukturen auf hochmolekularen Werkstoffoberflächen des Trägermaterials als hochreaktive Aluminiumpartikel durch Aufbrechen von feinstverteilt in dem Trägermaterial enthaltenen nicht leitenden Aluminiumnitrid hergestellt und die Bereiche im Umfeld der Leiterbahnstruktur unverändert sind. Durch den hochmolekularen, das Aluminiumnitrid enthaltenden Werkstoff als Trägermaterial sind die Leiterbahnen unter Bildung von Stickstoff durch geringe Ablation von Polymer-Partikeln realisierbar, wobei durch die Aluminiumkeime eine im Strukturbereich mikroporöse Leiterstrukturoberfläche gebildet ist, die eine feste Verankerung des stromlosen Metallaufbaus und dadurch eine hohe Haftfestigkeit der aufmetallisierten Leiterbahnen bewirkt.

Dabei erweist es sich zudem als besonders praxisgerecht, wenn das nicht leitende Trägermaterial zusätzlich zu Aluminiumpartikeln höhere Oxide mit der Struktur der Spinelle oder organische thermisch stabile Metallchelatkomplexe enthält, sodass die Aluminiumpartikel als Beimischung weiterer, ebenfalls als Basis für die Erzeugung der Leiterbahnstrukturen dienende Partikel, beispielsweise Metallkeime, die durch Aufbrechen von feinstverteilt in dem Trägermaterial enthaltenen nicht leitenden Metallverbindungen mittels elektromagnetische Strahlung eine optimale Anpassung an unterschiedliche Anforderungen gestatten.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt jeweils in einer Prinzipsskizze in
- Fig.1: eine perspektivische Darstellung eines Trägermaterials bei der Herstellung von Leiterbahnstrukturen mittels elektromagnetischer Strahlung;
- Fig.2: eine entlang der Linie II-II geschnittene und vergrößerte Darstellung eines Abschnittes des in Figur 1 gezeigten Trägermaterials;
- Fig.3: eine perspektivische Darstellung des in Figur 1 gezeigten Trägermaterials in einem Metallisierungsbad;
- Fig.4: die in Figur 2 gezeigte Schnittdarstellung des Trägermaterials mit einer Kupferschicht.

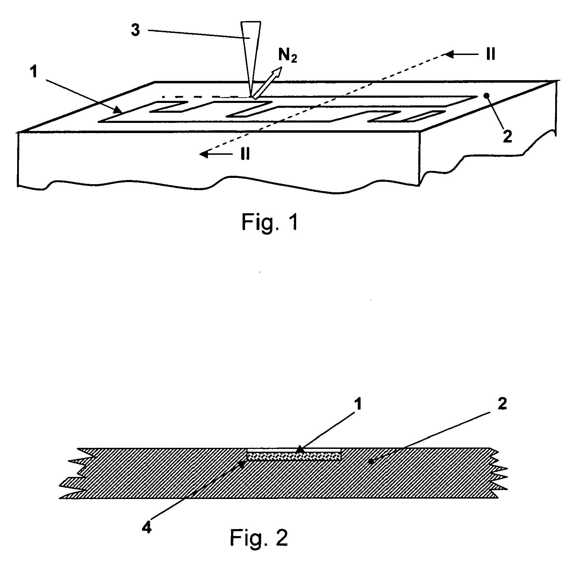

Das erfindungsgemäße Verfahren sowie die auf diese Weise realisierbare Herstellung von Leiterbahnstrukturen 1 wird anhand der Figuren 1 bis 3 näher dargestellt. Dabei wird ein plattenförmiges Trägermaterial 2 zunächst einer selektiven elektromagnetischen Strahlung 3 eines Nd:YAG-Lasers ausgesetzt, um die Leiterbahnstrukturen 1 auf dem Trägermaterial 2 als hochreaktive Aluminiumpartikel durch Aufbrechen von feinstverteilt in dem Trägermaterial 2 enthaltenen nicht leitenden Aluminiumnitrid zu erzeugen. Gleichzeitig wird dabei Stickstoff freigesetzt, welcher eine unerwünschte Oxidation der Aluminiumpartikel verhindert.

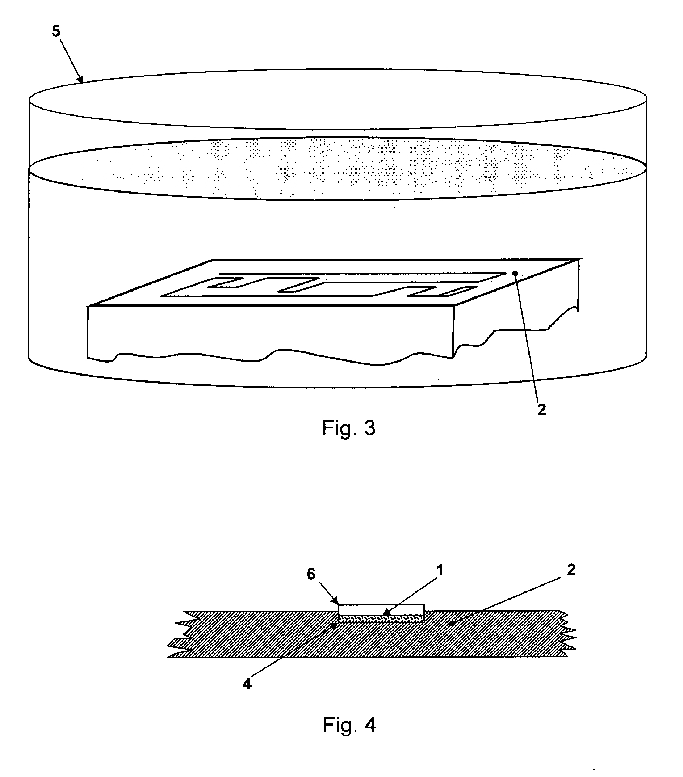

Wie in der Schnittdarstellung der Figur 2 zu erkennen, führt das Aufbrechen des in dem Trägermaterial 2 enthaltenen nicht leitenden Aluminiumnitrids in Form einer leitenden Schicht aus Aluminiumpartikeln zugleich zu einer Ablation der oberflächennahen Schicht des Trägermaterials 2, sodass die Aluminiumpartikel in einer nutenförmigen Ausnehmung 4 entstehen. Diese Ausnehmung 4 begünstigt neben der dadurch erzeugten haftvermittelnden Strukturoberfläche der Aluminiumpartikel den in Figur 3 gezeigten stromlosen Schichtaufbau in einem Metallisierungsbad 5.

Im Anschluss an eine Behandlung in einem Ultraschall-Reinigungsbad wird das Trägermaterial 2 beispielsweise mittels eines nicht dargestellten Gestells in das als ein handelsübliches chemisch reduktives Verkupferungsbad ausgeführte Metallisierungsbad gehängt 5. Hier werden in den bestrahlten Bereichen die in Figur 6 dargestellten Kupferschichten 6 stromlos auf die Leiterbahnstrukturen 1 aufgebaut.

## Patentansprüche

1. Verfahren zur Herstellung einer Leiterbahnstruktur auf einem stofflich modifizierten hochmolekularen Werkstoff als Trägermaterial in einem stromlosen Metallisierungsbad, **dadurch gekennzeichnet, dass** die Leiterbahnstruktur auf einer hochmolekularen Werkstoffoberfläche des Trägermaterials als elektrisch leitfähige Oberflächenphasen mit hochreaktiven Aluminiumpartikeln durch Aufbrechen von feinstverteilt in dem Trägermaterial enthaltenen nicht leitenden Aluminiumnitrid erzeugt wird, die gleichzeitig unter Stickstoffbildung und Ablation des hochmolekularen Werkstoffes in hoher Konzentration freigesetzt werden, wobei die Bereiche im Umfeld der Leiterbahnstruktur unverändert verbleiben.

2. Verfahren nach Anspruch 1, **dadurch gekennzeichnet, dass** eine Metallisierung der Leiterbahnstruktur des Trägermaterials in einem stromlosen Metallisierungsbad durchgeführt wird.

3. Verfahren nach den Ansprüchen 1 oder 2, **dadurch gekennzeichnet, dass** bei der Metallisierung zumindest Chrom, Kupfer, Nickel und/oder Gold aufgebracht wird.

4. Verfahren nach zumindest einem der vorhergehenden Ansprüche, **dadurch gekennzeichnet, dass** die elektromagnetische Strahlung eines Lasers eingesetzt wird.

5. Verfahren nach Anspruch 4, **dadurch gekennzeichnet, dass** die elektromagnetische Strahlung eines Lasers des Wellenlängenbereiches von 0,125 bis 11,0 µm eingesetzt wird.

6. Verfahren nach zumindest einem der vorhergehenden Ansprüche, **dadurch gekennzeichnet, dass** im Bereich der zu erzeugenden Leiterbahnstruktur mittels der elektromagnetischen Strahlung gleichzeitig hochreaktive Aluminium-Partikel unter Stickstoffbildung und Abtrag des hochmolekularen Werkstoffes, insbesondere Polymerabtrag, freigesetzt und dann chemisch reduktiv metallisiert werden.

7. Verfahren nach zumindest einem der vorhergehenden Ansprüche, **dadurch gekennzeichnet, dass** das thermisch hochstabile, in wässrigen sauren und alkalischen Metallisierungsbädern beständige und nicht lösliche Aluminiumnitridpulver in zumindest eine hochmolekulare Werkstoffoberfläche des Trägermaterials mit an sich bekannten Verfahren eingearbeitet und das Trägermaterial zu Bauteilen verarbeitet und/oder das Trägermaterial auf Bauteile als eine Beschichtung aufgetragen wird.

8. Verfahren nach zumindest einem der vorhergehenden Ansprüche, **dadurch gekennzeichnet, dass** durch das Aufbrechen des in dem Trägermaterial enthaltenen Aluminiumnitrids die Aluminiumpartikel bei gleichzeitiger Ablation des hochmolekularen Werkstoffes, insbesondere des Polymers unter Stickstoffabspaltung gebildet und dabei eine haftvermittelnde Strukturoberfläche erzeugt wird.

9. Verfahren nach zumindest einem der vorhergehenden Ansprüche, **dadurch gekennzeichnet, dass** zur weiteren Erhöhung der Haftfestigkeit der Metallschicht ein Gemisch von Aluminiumnitrid mit 1 bis 5% Yttriumoxid eingesetzt wird.

10. Verfahren nach zumindest einem der vorhergehenden Ansprüche, **dadurch gekennzeichnet, dass** als nichtleitendes Trägermaterial ein Kunststoff oder eine Polymerkeramik eingesetzt wird.

11. Eine gemäß einem Verfahren nach zumindest einem der vorhergehenden Ansprüche geschaffene Leiterbahnstruktur (1) auf einem Trägermaterial (2), **dadurch gekennzeichnet, dass** die Leiterbahnstruktur (1) auf hochmolekularen Werkstoffoberflächen des Trägermaterials (2) als hochreaktive Aluminiumpartikel durch Aufbrechen von feinstverteilt in dem Trägermaterial (2) enthaltenen nicht leitenden Aluminiumnitrid hergestellt und die Bereiche im Umfeld der Leiterbahnstruktur (1) unverändert sind.

12. Leiterbahnstruktur (1) nach Anspruch 11, **dadurch gekennzeichnet, dass** das nichtleitende Trägermaterial (2) zusätzlich zu Aluminiumpartikein höhere Oxide mit der Struktur der Spinelle und/oder organische thermisch stabile Metallchelatkomplexe enthält.

13. Leiterbahnstruktur (1) nach Anspruch 11 oder 12, **dadurch gekennzeichnet, dass** das nichtleitende Trägermaterial (2) einen Kunststoff oder eine Polymerkeramik aufweist.
